# FASCICULE DE BREVET EUROPEEN

(11) **EP 4 297 091 B1**
(45) Date de publication et mention de la délivrance du brevet: **25.02.2026**
(21) Numéro de dépôt: 23180760.3
(22) Date de dépôt: 21.06.2023
(51) Int. Cl.: H10D 30/67, H10D 86/00

(54) **DISPOSITIF MICROÉLECTRONIQUE À DEUX TRANSISTORS À EFFET DE CHAMP PRÉSENTANT UNE ÉLECTRODE COMMUNE**
MIKROELEKTRONISCHE ANORDNUNG MIT ZWEI FELDEFFEKTTRANSISTOREN MIT EINER GEMEINSAMEN ELEKTRODE
MICROELECTRONIC DEVICE WITH TWO FIELD EFFECT TRANSISTORS HAVING A COMMON ELECTRODE

(30) Priorité: 22.06.2022 FR 2206161
(43) Date de publication de la demande: 27.12.2023
(73) Titulaire: Commissariat à l'Energie Atomique et aux Energies Alternatives, 75015 Paris (FR)
(72) Inventeur: BARRAUD, Sylvain, 38054 GRENOBLE Cedex 09 (FR); LACORD, Joris, 38054 GRENOBLE Cedex 09 (FR)
(74) Mandataire: Hautier IP

(56) Documents cités:
- WO-A1-2021/050194
- US-A1- 2011 187 412
- US-A1- 2014 167 167
- CRISTOLOVEANU SORIN ET AL: "A Review of Sharp-Switching Devices for Ultra-Low Power Applications", IEEE JOURNAL OF THE ELECTRON DEVICES SOCIETY, IEEE, USA, vol. 4, no. 5, 1 September 2016 (2016-09-01), pages 215 - 226, XP011620443, DOI: 10.1109/JEDS.2016.2545978

## Description

### DOMAINE TECHNIQUE

La présente invention concerne le domaine de la microélectronique et plus particulièrement les technologies CMOS (de l'anglais « Complementary Metal Oxide Semiconductor », pouvant se traduire en français par « métal-oxyde-semiconducteur complémentaires ») avancées. Elle peut également trouver comme application avantageuse le domaine de l'apprentissage machine.

### ETAT DE LA TECHNIQUE

Différents types de transistors sont actuellement utilisés dans les circuits électroniques pour réaliser de nombreuses fonctions (circuits logiques, amplification, modulation de signaux...).

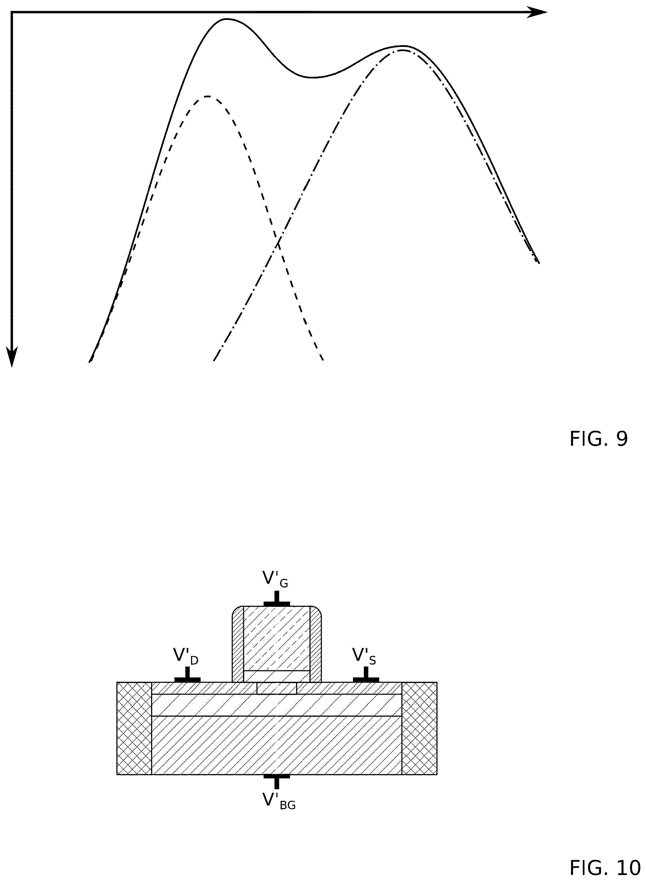

Une des structures les plus utilisées actuellement est le transistor FDSOI (de l'anglais « Fully Depleted Silicon On Insulator », pouvant être traduit en français par « silicium sur isolant entièrement déserté »), représenté en figure 10. Cette technologie consiste à placer une fine couche isolante sous la couche de semiconducteur, par exemple de silicium, de sorte à créer une barrière permettant notamment d'éviter les fuites de courant. Les transistors FDSOI sont privilégiés dans les applications basse consommation. Exemples de ce type de structures sont fournis par US2014/167167 A1.Autres dispositifs connus sont divulgués dans le document WO2021/050194 A1 et dans le document US 2011/187412 A1.

Les transistors Z²FET sont, eux, notamment employés pour des applications mémoire. Il s'agit d'une diode p-i-n polarisée en direct dont le canal intrinsèque est seulement partiellement recouvert par une grille avant.

Un objectif de la présente invention est de proposer une alternative aux dispositifs existants tout en présentant des performances au moins équivalentes et/ou en permettant de réaliser des fonctions pour lesquelles tous les dispositifs actuels ne peuvent pas être employés.

### RESUME

Pour atteindre cet objectif, un premier aspect concerne un dispositif microélectronique comprenant :
- un premier transistor à effet de champ comprenant un premier drain, une première source, une première grille et un premier diélectrique de grille,
- une première zone dopée, constituant l'un parmi le premier drain et la première source,
- une deuxième zone dopée, constituant l'autre parmi le premier drain et la première source,

Le dispositif comprend de plus :
- un deuxième transistor à effet de champ comprenant un deuxième drain, une deuxième source, une deuxième grille et un deuxième diélectrique de grille,
- une troisième zone dopée, constituant la deuxième source si la première zone dopée constitue le premier drain, ou le deuxième drain, si la première zone dopée constitue la première source,
- une quatrième zone dopée, constituant l'autre parmi le deuxième drain et la deuxième source,
- une couche diélectrique présentant une face supérieure au contact de la première zone dopée, de la deuxième zone dopée, de la troisième zone dopée et de la quatrième zone dopée,
- une grille arrière au contact d'une face inférieure de la couche diélectrique,

Il présente en outre la particularité que la deuxième zone dopée et la quatrième zone dopée forment une électrode commune.

L'objet ainsi défini constitue un dispositif microélectronique pouvant remplacer dans de nombreuses applications les transistors actuellement utilisés. Ce dispositif peut présenter en outre des fonctionnalités nouvelles par rapport aux dispositifs existants. De manière avantageuse, il permet de générer des caractéristiques courant-tension présentant une forme de type gaussienne, utilisables par exemple dans des applications mémoire ou d'apprentissage machine (« machine learning » en anglais).

Un deuxième objet concerne une unité de stockage à mémoire non-volatile comprenant un dispositif tel que défini précédemment.

Un troisième objet concerne un procédé de contrôle du dispositif ou de l'unité de stockage dans lequel la première tension de commande V₁₁₀ est appliquée à la première zone dopée et la deuxième tension de commande V₂₁₀ est appliquée à la première zone dopée, et dans lequel :
- La première tension de commande V₁₁₀ constitue une tension de source V_{S} du dispositif et la deuxième tension de commande V₂₁₀ constitue une tension de drain V_{D} du dispositif, ou
- La deuxième tension de commande V₂₁₀ constitue la tension de source V_{S} du dispositif et la première tension de commande V₁₁₀ constitue la tension de drain V_{D} du dispositif.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1A à 1F représentent chacune un dispositif selon un mode de réalisation de l'invention.
Les figures 2A, 2C, 3A, 3C, 4A, 4C, 5A et 5C représentent des caractéristiques courant-tension du dispositif selon l'un des modes de réalisation de l'invention obtenues par simulation. Les courbes des figures 2A, 2C 3A et 3C sont représentées en échelle linéaire, l'échelle à considérer est donc l'échelle représentée à droite de chacun de ces graphiques.
Les figures 2B, 2D, 3B, 3D, 4B, 4D, 5B et 5D sont des tableaux récapitulant les paramètres appliqués lors des simulations des figures 2A, 2C, 3A, 3C, 4A, 4C, 5A et 5C.
La figure 6 illustre la courbe caractéristique de la polarisation en fonction du champ appliqué d'un matériau ferroélectrique dans sa phase ferroélectrique.
Les figures 7A, 7C, 7E et 7G représentent des caractéristiques courant-tension du dispositif selon l'un des modes de réalisation de l'invention obtenues par simulation. Les courbes des figures 7A et 7C sont représentées en échelle logarithmique, l'échelle à considérer est donc l'échelle représentée à gauche sur chacun de ces graphiques. Les courbes des figures 7E et 7G sont représentées en échelle linéaire, l'échelle à considérer est donc l'échelle représentée à droite sur chacun de ces graphiques.
Les figures 7B, 7D, 7F et 7H sont des tableaux récapitulant les paramètres appliqués lors des simulations des figures 7A, 7C, 7E et 7G.
Les figures 8A et 8B illustrent une application pouvant être faite du dispositif selon l'un des modes de réalisation de l'invention.
La figure 9 représente le mélange gaussien obtenu par combinaison linéaire de plusieurs composantes gaussiennes.
La figure 10 représente un transistor FDSOI tel que connu de l'art antérieur.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un mode de réalisation, la deuxième zone dopée et la quatrième zone dopée sont électriquement connectées par une couche électriquement conductrice, de préférence métallique.

Selon un exemple, la couche électriquement conductrice est à base de siliciure métallique.

Selon un exemple, la couche électriquement conductrice recouvre directement au moins une partie d'une face supérieure de la deuxième zone dopée et au moins une partie d'une face supérieure de la quatrième zone dopée.

Selon un exemple, la couche électriquement conductrice recouvre directement une partie de la face supérieure de la couche diélectrique et sépare la deuxième zone dopée de la quatrième zone dopée.

Selon un exemple, la deuxième zone dopée et la quatrième zone dopée présentent des dopages distincts parmi un dopage de type N et un dopage de type P.

Selon un mode de réalisation, le dispositif comprend une première électrode et une deuxième électrode, la première zone dopée est au contact de la première électrode qui est configurée pour recevoir une première tension de commande V₁₁₀ et la troisième zone dopée est au contact de la deuxième électrode qui est configurée pour recevoir une deuxième tension de commande V₂₁₀.

Selon un exemple :
- La première tension de commande V₁₁₀ constitue une tension de source V_{S} du dispositif et la deuxième tension de commande V₂₁₀ constitue une tension de drain V_{D} du dispositif, ou
- La deuxième tension de commande V210 constitue une tension de source V_{S} du dispositif et la première tension de commande V₁₁₀ constitue une tension de drain V_{D} du dispositif.

Selon un mode de réalisation, le dispositif comprend une première électrode de grille et une deuxième électrode de grille, la première grille est au contact de la première électrode de grille qui est configurée pour recevoir l'application d'une première tension de grille V_{G1} et la deuxième grille est au contact de la deuxième électrode de grille qui est configurée pour recevoir l'application d'une deuxième tension de grille V_{G2}.

Selon un mode de réalisation, le dispositif comprend une électrode de grille arrière et la grille arrière est au contact de l'électrode de grille arrière qui est configurée pour recevoir l'application d'une tension de grille arrière V_{BG}.

Selon un mode de réalisation, le dispositif comprend en outre un circuit de contrôle configuré pour appliquer :
- la première tension de commande V₁₁₀ sur la première électrode,
- la deuxième tension de commande V₂₁₀ sur la deuxième électrode,
- la première tension de grille V_{G1} sur la première électrode,
- la deuxième tension de grille V_{G2} sur la deuxième électrode,
- la tension de grille arrière V_{BG} sur l'électrode de grille arrière,
la première tension de commande V₁₁₀, la deuxième tension de commande V₂₁₀, la première tension de grille V_{c1}, la deuxième tension de grille V_{G2} et la tension de grille arrière V_{BG} pouvant prendre différentes valeurs et au moins des valeurs comprises entre -5 et 5 V.

Selon un exemple, V_{G2} = ± V_{G1} + ΔV_{G}, et avec ΔV_{G} compris entre -5 et +5 V.

Selon un exemple, V_{G2} = V_{G1}.

Selon un exemple, V_{G2} = -V_{G1}.

Selon un exemple, le premier transistor et le deuxième transistor sont séparés d'une distance L supérieure à 50 nm, et/ou inférieure à 500 nm.

Selon un mode de réalisation, la deuxième zone dopée et la quatrième zone dopée présentent un dopage de même type parmi un dopage de type N et un dopage de type P, et la première zone dopée et la troisième zone dopée présentent un dopage de l'autre type.

Selon un exemple, la couche diélectrique présente une épaisseur e₃₀₀ entre sa face inférieure et sa face supérieure inférieure ou égale à 25 nm, de préférence inférieure à 5 nm.

Selon un mode de réalisation, le premier diélectrique de grille et le deuxième diélectrique de grille sont à base d'un matériau ferroélectrique.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant, soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi un matériau à base d'un matériau IV-IV (ou III-N) peut comprendre un matériau IV-IV (respectivement III-N) additionné de dopants. De même, une couche à base de GaN comprend typiquement du GaN et des alliages d'AlGaN ou d'InGaN.

Le terme « matériau III-V » fait référence à un semi-conducteur composé d'un ou plusieurs éléments de la colonne III et de la colonne V du tableau périodique de Mendeleïev. On compte parmi les éléments de la colonne III le bore, le gallium, l'aluminium ou encore l'indium. La colonne V contient par exemple l'azote, l'arsenic, l'antimoine et le phosphore.

Dans le cadre de cette invention, on entend par matériau « électriquement conducteur » un matériau présentant un niveau de conductivité électrique supérieur à 0.5×10⁶ S/m (1 Siemens = 1 S = 1 m⁻².kg⁻¹.s³.A²).

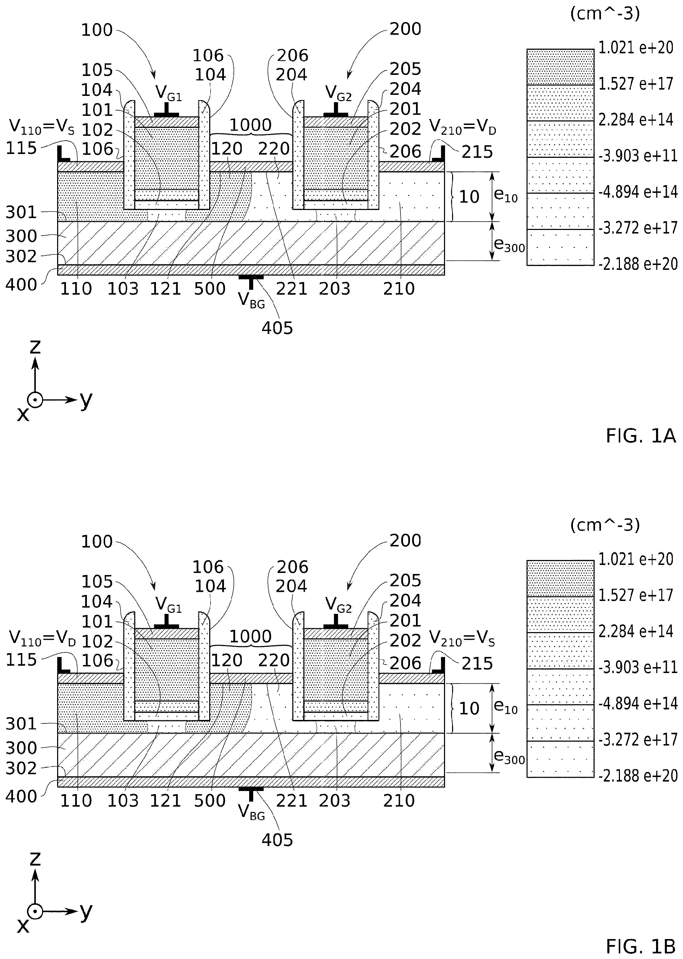

Un repère, de préférence orthonormé, comprenant les axes x, y, z est représenté en figure 1A. Ce repère est applicable par extension aux autres figures.

Dans la présente demande de brevet, on parlera préférentiellement d'épaisseur pour une couche et de hauteur pour une structure ou un dispositif. L'épaisseur est prise selon une direction normale au plan d'extension principal de la couche, et la hauteur est prise perpendiculairement au plan de base XY. Ainsi, une couche présente typiquement une épaisseur selon z, lorsqu'elle s'étend principalement le long d'un plan XY, et un élément en saillie, par exemple une tranchée d'isolation, présente une hauteur selon z. Les termes relatifs « sur », « sous », « sous-jacent » se réfèrent préférentiellement à des positions prises selon la direction z.

Le dispositif selon différents modes de réalisation de l'invention va maintenant être décrit en référence aux figures 1A à 1F.

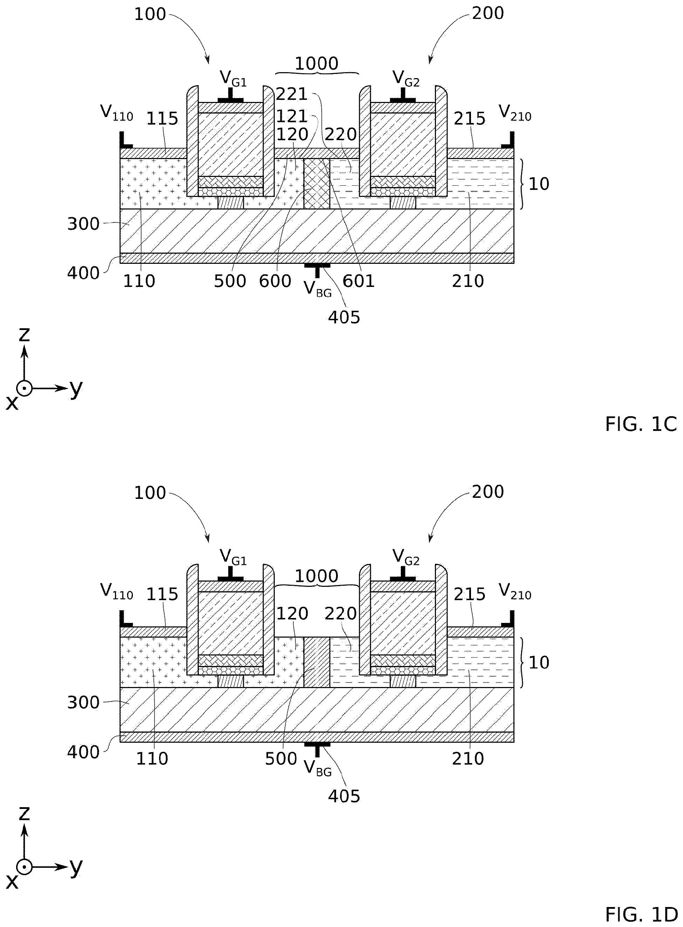

Les figures 1A et 1B sont issues de simulations numériques. Elles constituent des cartographies du dopage au sein du dispositif 1. Les figures 1C à 1F sont, elles, des représentations schématiques du dispositif 1. Il est à noter que sur les figures 1C à 1F, les zones dopées N sont illustrées par un motif présentant une forme de croix et les zones dopées P par un motif présentant une forme de tiret.

Le dispositif 1 comprend un premier transistor à effet de champ 100 et un deuxième transistor à effet de champ 200. De préférence, il ne comprend pas d'autres transistors ou pour le moins pas d'autres transistors dont une région dopée forme une électrode commune avec une région dopée de l'un ou l'autre des deux premiers transistors.

Le premier transistor 100 comprend un premier drain, une première source, une première grille 101 et un premier diélectrique de grille 102. Comme il sera détaillé plus avant, il peut s'agir d'un transistor n-MOS, d'un transistor p-MOS ou encore d'un transistor TFET (de l'anglais « Tunnel Field-Effect Transistor », pouvant être traduit par « transistor à effet tunnel »).

Le premier diélectrique de grille 102 s'étend sous la première grille 101. La première zone dopée 110 et la deuxième zone dopée 120 sont chacune en contact avec un premier canal 103, dit de conduction mais qui peut aussi être une zone désertée de porteurs, les séparant. Ce premier canal 103 est au contact de la face inférieure du premier diélectrique de grille 102.

Le premier transistor 100 comprend de plus typiquement des espaceurs 104 permettant d'isoler la première grille 101 du premier drain d'une part et de la première source d'autre part. Ces espaceurs 104 couvrent typiquement les flancs latéraux de la première grille 101. Ils sont entre autres destinés à limiter le couplage capacitif parasite entre la première grille 101 et la première source d'une part et le premier drain d'autre part.

Le deuxième transistor 200 comprend un deuxième drain, une deuxième source, une deuxième grille 201, un deuxième diélectrique de grille 202 et un deuxième canal 203 lui aussi dit de conduction mais pouvant aussi être une zone désertée de porteurs. Les caractéristiques du premier transistor 100 peuvent être transposées mutatis mutandis au deuxième transistor 200.

Le premier transistor 100 et le deuxième transistor 200 sont séparés d'une distance L mesurée dans le plan XY et définie comme la distance entre un flanc 106 du premier transistor 100 et un flanc 206 du deuxième transistor 200 lui faisant face. Les flancs 106, 206 des transistors 100, 200 correspondent typiquement aux flancs des espaceurs 104, 204. La distance L est, pour des raisons de limitations technologiques lors de la fabrication du dispositif, de préférence supérieure à 50 nm. Dans un objectif d'optimisation de la densité de dispositifs pouvant être intégrés sur une puce, elle est de préférence inférieure à 500 nm.

La première zone dopée 110 et la deuxième zone dopée 120 peuvent constituer respectivement le premier drain et la première source, ou inversement.

De manière similaire, le dispositif comprend une troisième zone dopée 210 et une quatrième zone dopée 220 pouvant constituer respectivement le deuxième drain et la deuxième source, ou inversement.

La deuxième zone dopée 120 et la quatrième zone dopée 220 forment une électrode commune 1000.

Si ces deux zones présentent le même type de dopage parmi un dopage de type N et un dopage de type P, le simple fait qu'elles soient en contact permet de créer l'électrode commune 1000.

Si en revanche la deuxième zone dopée 120 et la quatrième zone dopée 220 présentent des dopages de types différents, ces dernières sont court-circuitées afin de former l'électrode commune 1000. Typiquement, pour réaliser ce court-circuit, on prévoit la présence d'une couche électriquement conductrice 500, de préférence métallique, au contact à la fois de la deuxième zone dopée 120 et de la quatrième zone dopée 220. Cette couche électriquement conductrice 500, que l'on nomme également couche métallique 500 est une couche continue assurant la connexion électrique de ces deux zones 120, 220. Elle est avantageusement à base d'un siliciure, c'est-à-dire un matériau composé de silicium et d'un ou plusieurs éléments métalliques. Par exemple, elle peut être à base de NiPtSi ou de NiSi. Elle présente avantageusement un niveau de résistivité électrique inférieur à 150 µΩ.cm et typiquement supérieur à 5 µΩ.cm.

On entend ici le terme « couche » au sens large. Il peut s'agir aussi bien d'un dépôt s'étendant principalement selon le plan XY que d'un élément présentant de faibles dimensions dans ce plan.

Selon un mode de réalisation illustré à la figure 1D, la couche métallique 500 peut séparer dans le plan XY les deuxième et quatrième zones dopées 120, 220. Selon un autre mode de réalisation avantageux illustré aux figures 1A et 1B, les deuxième et quatrième zones dopées 120, 220 sont en contact et la couche métallique 500 recouvre directement au moins une partie de chacune de leurs surfaces supérieures 121, 221. De préférence, dans ce mode de réalisation, la couche métallique 500 s'étend dans le plan XY d'un flanc 106 du premier transistor 100 à un flanc 206 du deuxième transistor 200. Avantageusement, la couche métallique 500 recouvre l'intégralité des faces supérieures 121, 221 des zones dopées 120, 220. Il est aussi possible que la couche 500 sépare les deuxième et quatrième zones dopées tout en les recouvrant également. Il est également possible, comme cela est illustré à la figure 1C, que la deuxième zone dopée 120 et la quatrième zone dopée 220 soient séparées dans le plan XY par un élément isolant 600 et connectées électriquement par l'intermédiaire de la couche métallique 500 recouvrant cette fois à la fois les surfaces supérieures 121, 221 des deuxième et quatrième zones dopées 120, 220 et la face supérieure 601 de l'élément isolant 600.

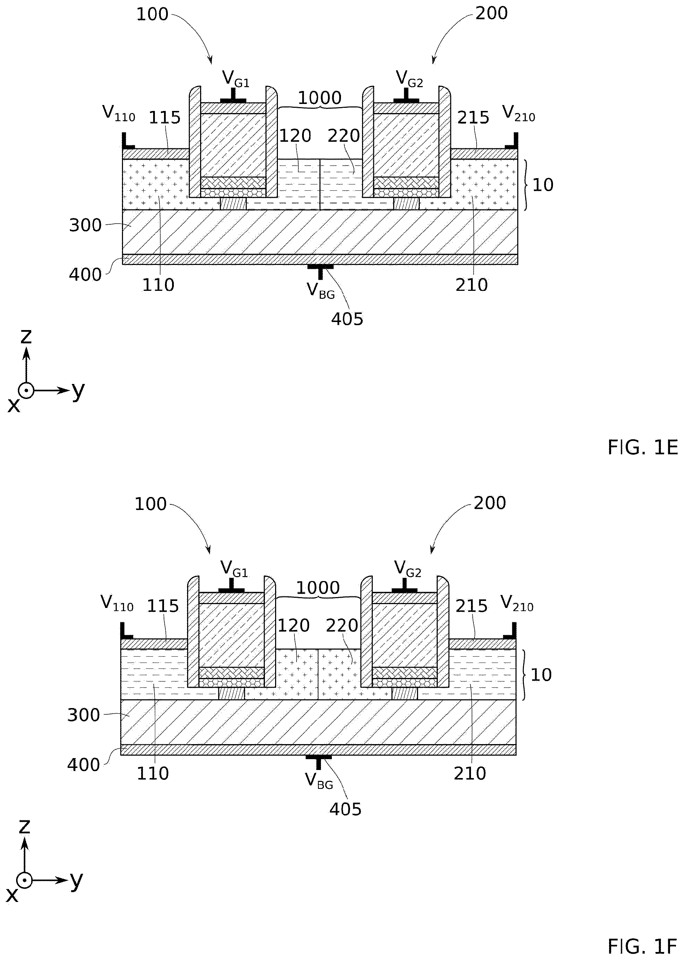

Si la couche électriquement conductrice 500 n'est pas nécessaire dans le cas où la deuxième zone dopée 120 et la quatrième zone dopée 220 présentent le même type de dopage (cas illustré aux figures 1E et 1F), il est cependant envisageable qu'elle soit présente.

Les zones dopées 110, 120, 210, 220 se trouvent de préférence toutes dans une couche active 10. Il en est de préférence de même pour le premier canal 103 et le deuxième canal 203. Ainsi, de préférence, les zones dopées 110, 120, 210, 220 et les canaux 103, 203 sont tous à base du même matériau : celui de la couche active 10. La couche active 10 est de préférence à base d'au moins un matériau IV-IV. Par exemple, ce matériau est à base de silicium. La couche active 10 peut également être à base d'au moins un matériau III-V, de préférence à base d'au moins un matériau III-N. Par exemple, ce matériau est à base de GaN. La couche active 10 peut également être formée par des monocouches de dichalcogénure de métal de transition (couramment désignées par l'acronyme anglais TMD, « Transition-Metal Dichalcogenide monolayers »), par exemple de type MoS₂ ou WS₂. Il peut s'agir d'une couche homogène, formée typiquement d'un unique matériau. La couche active 10 présente typiquement une face supérieure 11 et une face inférieure 12 s'étendant toutes les deux principalement dans le plan XY du repère orthogonal XYZ. Elle présente selon la direction z une épaisseur e₁₀. Si la couche active 10 est à base de silicium, l'épaisseur e₁₀ varie typiquement de 5 nm à 50 nm. Si en revanche elle est formée par des matériaux à deux dimensions tels que les monocouches TMD, la couche active 10 peut présenter une valeur d'épaisseur e₁₀ aussi faible que quelques nanomètres.

Certains éléments constituant les transistors 100, 200 peuvent avoir été au moins partiellement formés à partir d'une couche continue dite couche de fabrication. Par exemple, certaines régions de la couche de fabrication auront pu être transformées pour former les diélectriques de grille 103, 203 et/ou les espaceurs 104, 204. La couche de fabrication peut également avoir été gravée puis différents dépôts auront pu être réalisés sur cette couche de fabrication afin de former les diélectriques de grille 103, 203, espaceurs 104, 204 et/ou grilles 101, 201. Les régions non transformées ou gravées de la couche de fabrication font alors partie de la couche active 10. La couche active 10 peut de plus comprendre des zones ayant été épitaxiées à partir de la couche de fabrication.

Le dispositif 1 comprend de plus une couche diélectrique 300 présentant une face supérieure 301 et une face inférieure 302 s'étendant toutes les deux principalement dans des plans parallèles au plan XY du repère orthogonal. La face supérieure 301 de la couche diélectrique 300 se trouve au contact de la première zone dopée 110, de la deuxième zone dopée 120, de la troisième zone dopée 210 et de la quatrième zone dopée 220. La couche diélectrique 300 constitue ainsi un diélectrique enterré commun aux deux transistors 100, 200 et donc de façon générale un diélectrique enterré pour le dispositif 1. Elle présente selon la direction z une épaisseur e₃₀₀.

Le dispositif 1 comprend en outre une grille arrière 400 au contact de la face inférieure 302 de la couche diélectrique 300.

Le dispositif 1 peut comprendre les électrodes ou reprises de contact suivantes :
- une première électrode 115 au contact de la première zone dopée 110,
- une deuxième électrode 215 au contact de la troisième zone dopée 210,
- une première électrode de grille 105 au contact de la première grille 101,
- une deuxième électrode de grille 205 au contact de la deuxième grille 201,
- une électrode de grille arrière 405 au contact de la grille arrière 400,
chacune de ces électrodes étant configurée pour pouvoir recevoir l'application d'une tension. Ces électrodes sont typiquement des couches métalliques déposées au contact de chacune des zones dopées 110, 210 et grilles 101, 201, 400.

Plus précisément, on prévoit notamment que puissent être appliquées :
- une première tension de commande V₁₁₀ sur la première électrode 115,
- une deuxième tension de commande V₂₁₀ sur la deuxième électrode 215,
- une première tension de grille V_{G1} sur la première électrode 105,
- une deuxième tension de grille V_{G2} sur la deuxième électrode 205,
- une tension de grille arrière V_{BG} sur l'électrode de grille arrière 405.

De préférence, toutes les électrodes 115, 215, 105, 205 et 405 sont accessibles - c'est-à-dire que des tensions peuvent leur être appliquées -depuis une même face dite face avant du dispositif 1. Dans cette optique, la grille arrière 400 fait avantageusement saillie par rapport à la couche diélectrique 300 de sorte à permettre une reprise de contact de ladite grille arrière 400 depuis la face avant du dispositif 1. La couche diélectrique 300 peut en outre, au niveau de cette reprise de contact, présenter une surépaisseur. Cette surépaisseur correspond typiquement à la somme de l'épaisseur e₃₀₀ de la couche diélectrique 300 et de l'épaisseur e₁₀ de la couche active 10. L'électrode de grille arrière 405 se trouve alors de niveau selon la direction z avec la première électrode 115 et la deuxième électrode 215. Cela permet de faciliter leur fabrication simultanée. On prévoit alors avantageusement la présence d'au moins une tranchée d'isolation peu profonde (couramment désignée STI, acronyme anglais de « Shallow Trench Isolation ») permettant d'isoler électriquement la grille arrière 400 de la couche active 10.

Ainsi, le comportement du dispositif 1 peut être contrôlé au niveau de cinq points de commande. Les transistors FDSOI, couramment utilisés dans l'industrie microélectronique, qui présentent une unique grille en face avant, ne peuvent être contrôlés qu'au niveau de quatre points de commande (drain, source, grille avant, grille arrière, visibles sur la figure 10). Grâce à ce point de commande supplémentaire, il est possible de contrôler plus finement le comportement électrique du dispositif 1 par rapport à un transistor FDSOI classique. Cela confère également au dispositif 1 des fonctionnalités supplémentaires et permet de l'utiliser pour d'autres applications, comme cela sera détaillé plus avant.

La première tension de commande V₁₁₀ et la deuxième tension de commande V₂₁₀ constituent pour le dispositif 1 respectivement une tension de drain V_{D} et une tension de source V_{S}, ou inversement. Plus précisément :
- Si la première zone dopée 110 constitue la première source et la troisième zone dopée 210 le deuxième drain, alors la première tension de commande V₁₁₀ constitue la tension de source V_{S} du dispositif 1 et la deuxième tension de commande V₂₁₀constitue la tension de drain V_{D} du dispositif 1. Ce cas de figure est envisagé à la figure 1A.
- Si la première zone dopée 110 constitue le premier drain et la troisième zone dopée 210 la deuxième source, alors la première tension de commande V₁₁₀ constitue la tension de drain V_{D} du dispositif 1 et la deuxième tension de commande V₂₁₀ constitue la tension de source V_{S} du dispositif 1. Ce cas de figure est envisagé à la figure 1B.

En fonction du type des transistors 100, 200 (n-MOS, p-MOS, TFET), donc du type de dopage des zones dopées 110, 120, 210 et 220, le fonctionnement du dispositif 1 s'apparente lui-même au fonctionnement d'un transistor de type n-MOS, p-MOS ou TFET. Dans l'exemple illustré à la figure 1A, le premier transistor 100 est un transistor du type n-MOS, le deuxième transistor 200 est du type p-MOS, la source du dispositif 1 se trouve au niveau de la première zone dopée 110, qui est ici une zone dopée N, et le drain au niveau de la troisième zone dopée 210, ici dopée P. Dans cette configuration, le dispositif 1 en fonctionnement aura donc un comportement de type n-TFET.

Dans l'exemple illustré à la figure 1B, les transistors 100, 200 sont du même type que dans le mode de réalisation de la figure 1A, mais les tensions de commande V₁₁₀, V₂₁₀ appliquées sont telles que la source du dispositif 1 se trouve au niveau de la troisième zone dopée 210, ici dopée P, et que le drain se trouve au niveau de la première zone dopée 110, ici dopée N. Dans cette configuration, le dispositif 1 en fonctionnement aura un comportement de type p-TFET.

Il est à noter que la fonction de source ou de drain des zones 110, 120, 210 et 220 dépend des tensions qui leur sont appliquées, et plus exactement du signe des tensions V₁₁₀-V₁₂₀ et V₂₁₀-V₂₂₀. Ainsi, il est possible de faire passer le dispositif 1 d'un comportement n-TFET à un comportement p-TFET, et inversement, en changeant simplement le signe de ces différences de tension.

La figure 1E illustre une configuration dans laquelle les transistors 100, 200 sont tous les deux du type TFET et sont disposés de sorte à ce que l'électrode commune 1000 soit formée par le contact des zones dopées P de chacun des transistors. Dans cet exemple, le fonctionnement du dispositif 1 s'apparente à celui d'un transistor n-MOS. A l'inverse, dans l'exemple illustré à la figure 1F, l'électrode commune 1000 est formée par le contact des zones dopées N de deux transistors 100, 200 de type TFET. Le fonctionnement du dispositif est cette fois assimilable à celui d'un transistor p-MOS.

La tension de grille arrière joue, elle, dans le dispositif 1, un rôle majeur de commande.

De la même façon qu'un transistor de l'état de la technique, le dispositif 1 peut se trouver dans un état passant ou un état bloqué. A l'état passant, l'ensemble constitué du premier canal 103, de l'électrode commune 1000 et du deuxième canal 203 constitue un canal de conduction pour le dispositif 1. Le courant peut alors circuler entre la source et le drain du dispositif 1. A l'état bloqué, le premier canal 103 et le deuxième canal 203 agissent comme des canaux déplétés pour leurs transistors 100, 200 respectifs. L'ensemble constitué du premier canal 103, de l'électrode commune 1000 et du deuxième canal 203 est alors déserté de porteurs. Aucun courant ne circule alors dans le dispositif 1.

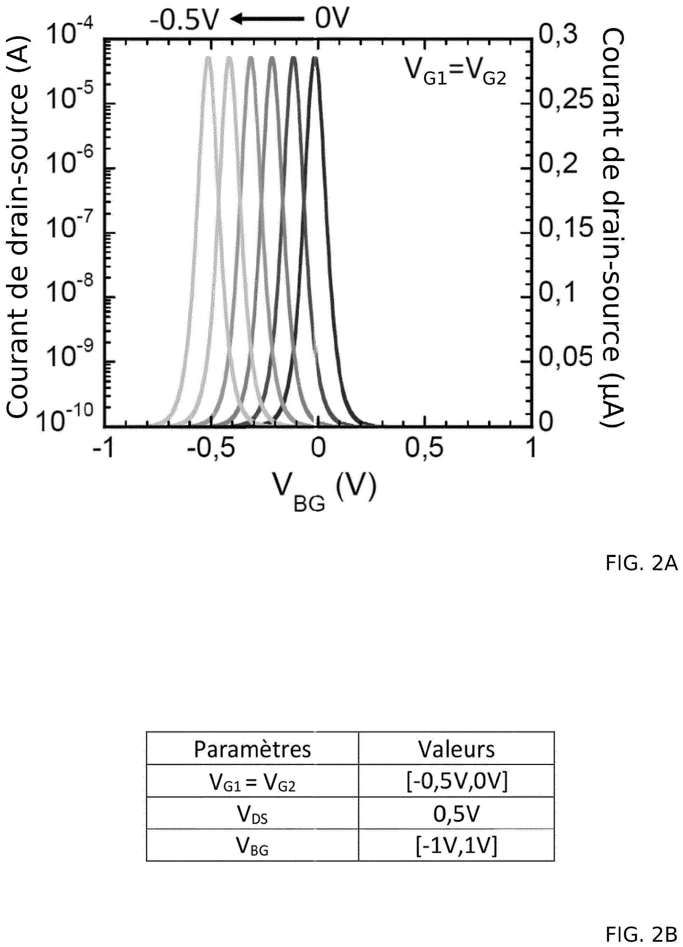

Toutes les simulations présentées dans les figures 2A à 5C et 7A à 9 allant maintenant être décrites ont été réalisées pour un dispositif 1 présentant les caractéristiques suivantes :
- Le premier transistor 100 est un transistor de type n-MOS,
- Le deuxième transistor 200 est un transistor de type p-MOS,
- La première zone dopée 110 constitue la source du transistor n-MOS 100 et la troisième zone dopée 210 constitue le drain du transistor p-MOS 200 (comportement de type n-FET). La tension drain-source V_{DS}=V_{D}-V_{S} du dispositif 1 est donc définie par V₂₁₀-V₁₁₀. Il est à noter que des simulations portant sur un dispositif 1 présentant un comportement assimilable à un transistor p-FET, n-MOS ou p-MOS permettraient de tirer des enseignements similaires sur les fonctions qu'il permet de réaliser.

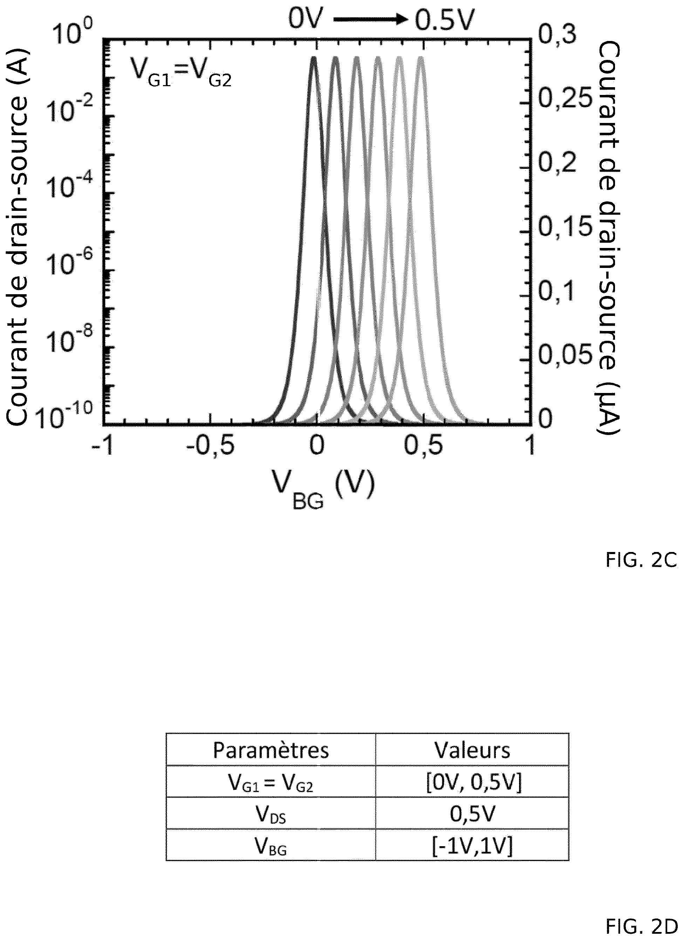

Les figures 2A et 2C montrent des caractéristiques courant-tension I_{D}=f(V_{BG}) du dispositif 1 obtenues à partir d'un modèle analytique. Au cours de cette simulation :
- la première tension de grille V_{G1} et la deuxième tension de grille V_{G2} ont été fixées à une même valeur. La simulation a été réalisée pour plusieurs valeurs de V_{G1}=V_{G2}, variant de 0 à -0,5V (figure 2A) et de 0 à 0,5V (figure 2C). Ces différentes simulations correspondent aux différentes courbes sur les figures 2A et 2C.
- la tension drain-source V_{DS} a été fixée à une valeur de 0,5V. Plus précisément, on a fixé Vs=0V et V_{D}=0,5V.
- la tension de grille arrière V_{BG} varie de -1V à 1V.
- on relève l'évolution du courant de drain-source I_{DS} circulant dans le dispositif 1 en fonction de V_{BG}.

Ces éléments sont récapitulés dans les tableaux présentés en figure 2B et 2D.

Ces figures illustrent la possibilité de générer à partir du dispositif 1 une caractéristique de type gaussienne. Les transistors FDSOI couramment utilisés dans l'industrie ne permettent pas d'obtenir ce type de courbes. Notamment, ils ne permettent pas d'obtenir une résistance différentielle négative comme c'est le cas ici. De plus, comme l'illustrent ces figures, faire varier la polarisation des deux grilles 101, 201 permet d'ajuster la valeur moyenne de la gaussienne. Plus précisément, ici, diminuer la valeur de V_{G1}=V_{G2} permet de diminuer la valeur moyenne de la courbe, et inversement. Les applications de ces propriétés du dispositif seront détaillées plus avant.

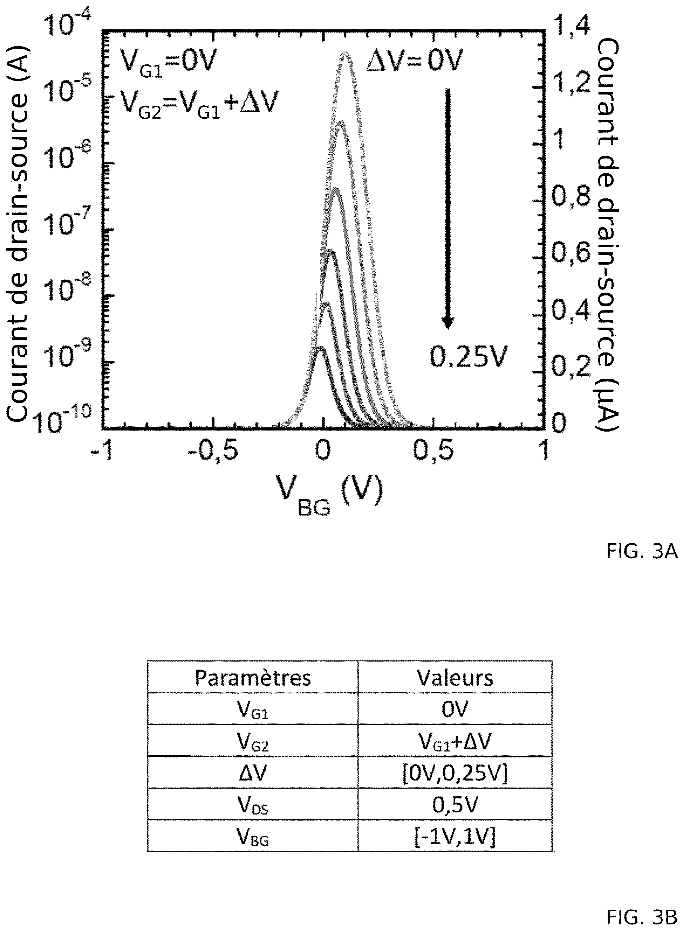

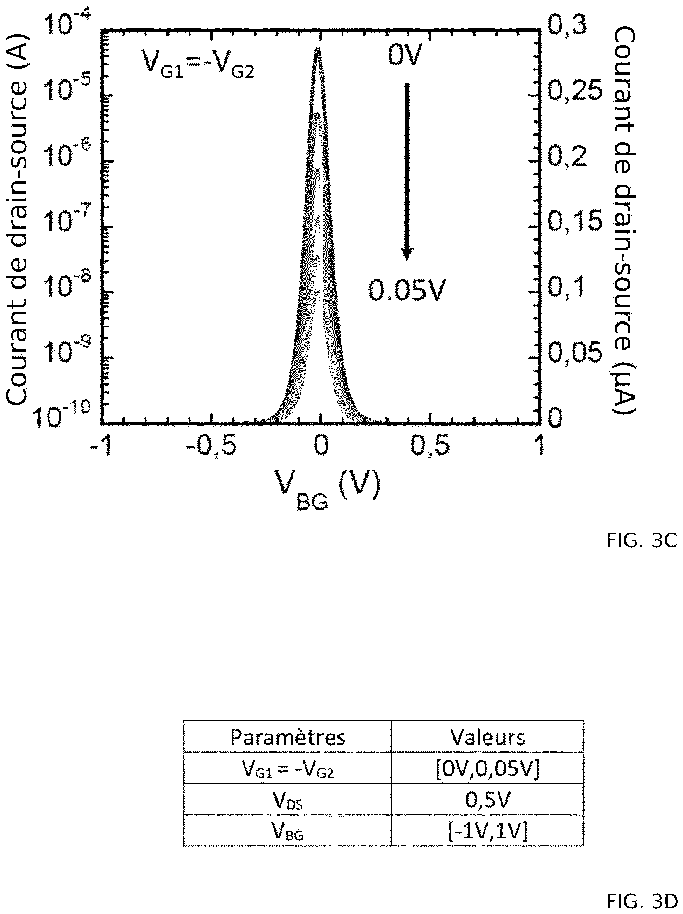

Les figures 3A et 3C montrent des caractéristiques courant-tension I_{D}=f(V_{BG}) obtenues à partir d'un modèle analytique du dispositif 1 pour d'autres relations liant V_{G1} et V_{G2}. Au cours de ces simulations :
- la première tension de grille V_{G1} et la deuxième tension de grille V_{G2} sont liées par les relations suivantes :
   i. Figure 3A : V_{G2}=V_{G1}+ΔV avec V_{G1}=0V. La simulation a été réalisée pour plusieurs valeurs de ΔV, variant de 0 à 0,25V. Ces différentes simulations correspondent aux différentes courbes sur la figure 3A.
   ii. Figure 3C : V_{G1}= -V_{G2}. La simulation a été réalisée pour plusieurs valeurs de V_{G1}= -V_{G2}, variant de 0 à 0,05V. Ces différentes simulations correspondent aux différentes courbes sur la figure 3C.
- la tension drain-source V_{DS} a été fixée à une valeur de 0,5V. Plus précisément, on a fixé Vs=0V et V_{D}=0,5V.
- la tension de grille arrière V_{BG} varie de -1V à 1V.
- on relève l'évolution du courant de drain-source I_{DS} circulant dans le dispositif 1 en fonction de V_{BG}.

On note que pour ces autres relations entre V_{G1} et V_{G2}, on obtient également les caractéristiques de type gaussienne.

Ces figures illustrent de plus que le choix des tensions appliquées sur les grilles 101, 201 en face avant permet de contrôler à la fois la valeur moyenne, comme cela avait déjà été montré pour V_{G1}=V_{G2}, et la hauteur de la gaussienne. On remarque notamment sur la figure 3C que pour V_{G1}= -V_{G2}, une augmentation en valeur absolue des tensions de grille V_{G1}, V_{G2} permet d'abaisser la valeur de la hauteur de la gaussienne tout en conservant une valeur moyenne constante. La figure 3A illustre la combinaison d'une variation de la valeur moyenne et de la hauteur de la gaussienne.

Ainsi, la présence de deux grilles 101, 201 en face avant permet un contrôle très précis de la forme et des valeur caractéristiques de la réponse en courant du dispositif 1 à une sollicitation en tension.

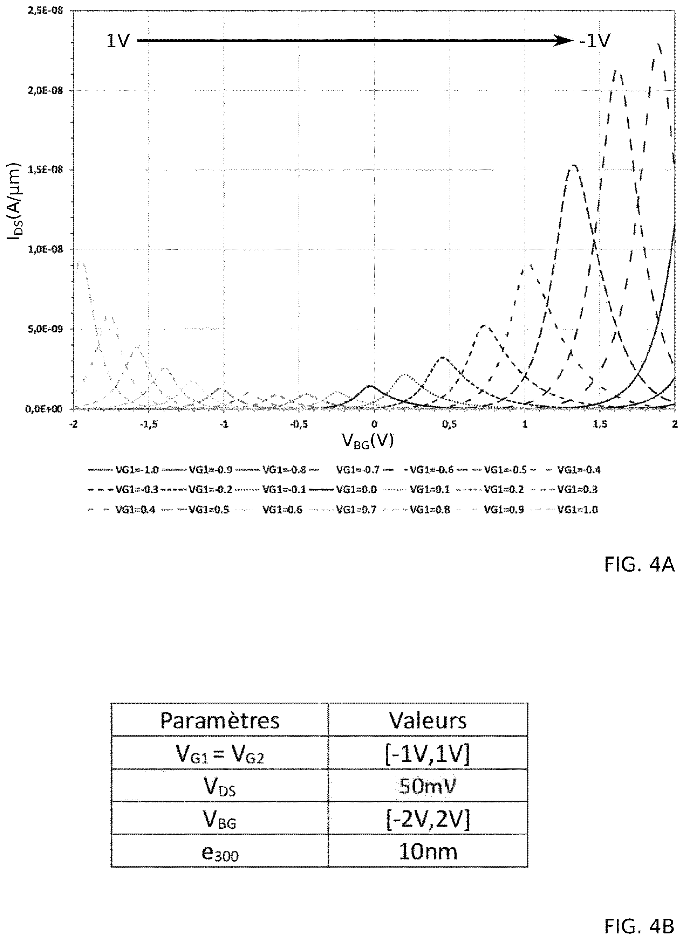

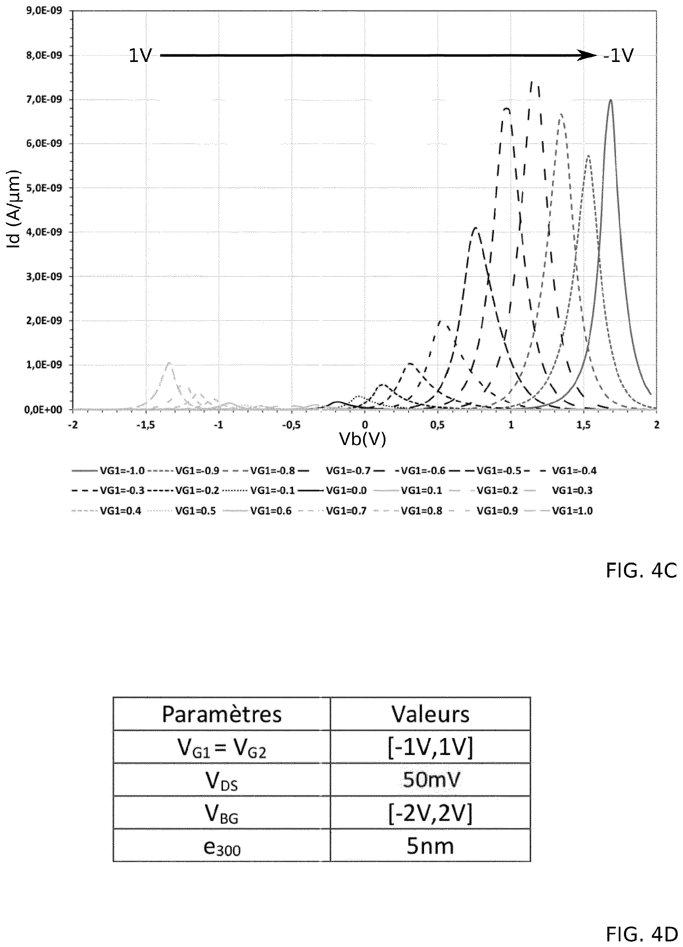

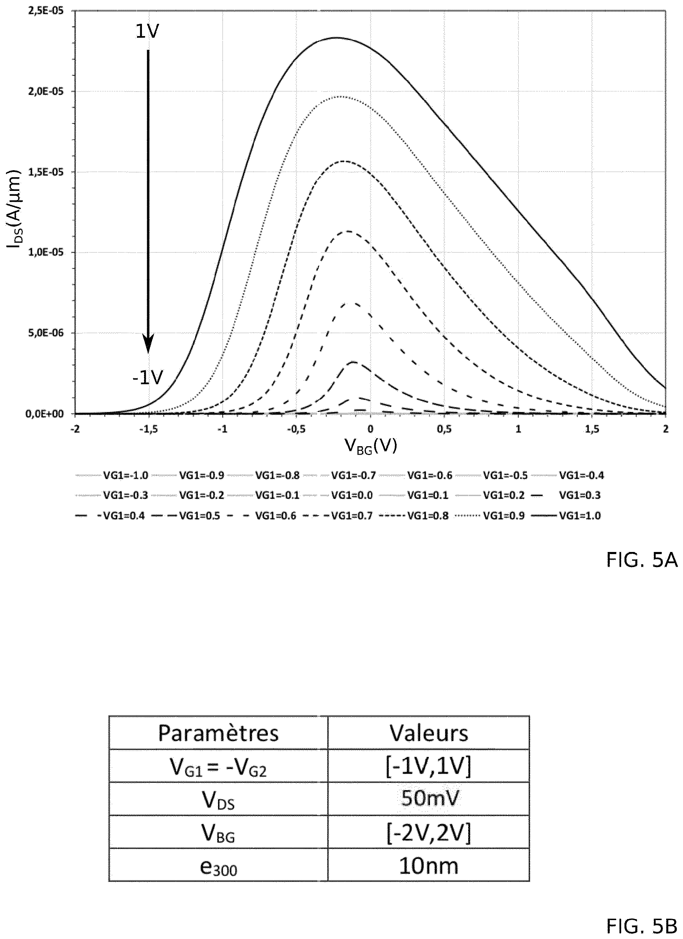

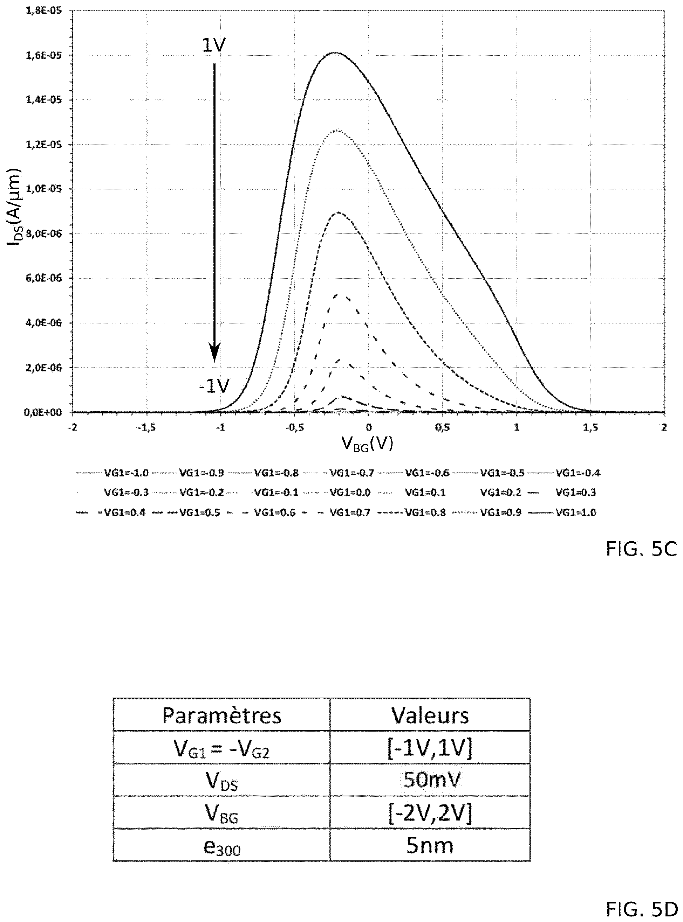

Les figures 4A, 4C, 5A et 5C constituent une étude de l'influence de l'épaisseur e₃₀₀ de la couche diélectrique 300 sur le fonctionnement du dispositif 1 par l'intermédiaire de caractéristiques courant-tension I_{D}=f(V_{BG}) obtenues par simulation TCAD (de l'anglais « Technology Computer Aided Design », pouvant être traduit en français par « conception technologique assistée par ordinateur »). Au cours de ces simulations :
- la première tension de grille V_{G1} et la deuxième tension de grille V_{G2} sont liées par les relations suivantes :
   i. Figures 4A et 4C : V_{G1}= V_{G2}. Les simulations ont été réalisées pour plusieurs valeurs de V_{G1}= V_{G2}, variant de -1V à 1V. Ces différentes simulations correspondent aux différentes courbes sur les figures 4A et 4C.
   ii. Figure 5A et 5C : V_{G1}= -V_{G2}. Les simulations ont été réalisées pour plusieurs valeurs de V_{G1}= -V_{G2}, variant de -1V à 1V. Ces différentes simulations correspondent aux différentes courbes sur les figures 4A et 4C.
- la tension drain-source V_{DS} a été fixée à une valeur de 0,5V.
- la tension de grille arrière V_{BG} varie de -2V à 2V.
- l'épaisseur e₃₀₀ de la couche diélectrique 300 a été fixée à :
   i. 10nm (1nm=10⁻⁹m) lors des simulations représentées en figures 4A et 5A.
   ii. 5nm lors des simulations représentées en figures 4C et 5C.
- on relève l'évolution du courant de drain-source I_{DS} circulant dans le dispositif 1 en fonction de V_{BG}.

Ces éléments sont récapitulés dans les tableaux présentés en figure 4B, 4D, 5B et 5D.

On remarque notamment que, quelle que soit la relation liant V_{G1} et V_{G2}, plus la couche diélectrique 300 est fine, plus la largeur à mi-hauteur - et donc l'écart type - de la gaussienne est faible. Dit autrement, plus le diélectrique enterré 300 est fin, meilleur est le contrôle électrostatique de la grille arrière 400 sur la réponse en courant du dispositif 1. Pour les applications visées, il est intéressant que l'écart-type soit le plus faible possible. L'épaisseur e₃₀₀ de la couche diélectrique 300 est donc avantageusement minimisée.

Il est également à noter que, comme l'illustre les figures 3A et 3C, plus la couche diélectrique 300 est fine, plus les gaussiennes obtenues pour différentes valeurs de V_{G1}=V_{G2} sont resserrées. Faire varier l'épaisseur e₃₀₀ permet donc également de contrôler la valeur moyenne de la gaussienne.

Ainsi, l'épaisseur e₃₀₀ de la couche diélectrique 300 est un autre levier d'ajustement des caractéristiques de la gaussienne pouvant être générée par le dispositif 1. Il s'agit cependant cette fois d'un paramètre fixé lors de sa fabrication et donc intrinsèque au dispositif. Typiquement, l'épaisseur e₃₀₀ est supérieure à 2nm et de préférence inférieure à 25nm.

Selon un mode de réalisation, les diélectriques de grille 102, 202 sont à base d'un matériau ferroélectrique. Par exemple, ils peuvent être à base de HfO₂, HfZrO₂, BaTiO3, Pb(Zr,Ti)O₃ (couramment désigné par le sigle PZT), SrBi₂Ta₂O₉ (SBT), BiFeO₃ (BFO), d'un oxyde de hafnium (HZO) dopé au silicium, ou encore d'un matériau du type AlₓSc₁₋ₓN.

Les matériaux ferroélectriques présentent la particularité de posséder une polarisation spontanée, dont la direction de polarisation peut être modifiée sous l'action d'un champ électrique et renversée de façon réversible. Ces matériaux sont notamment caractérisés par :
- leur température de T_{c} en-deçà de laquelle ils ont un comportement ferroélectrique,
- leur polarisation rémanente Pᵣ, qui est la valeur de la polarisation à champ nul,
- leur champ coercitif E_{c}, qui est la valeur du champ à appliquer pour renverses la polarisation,
- et enfin leur polarisation à saturation Pₛ.

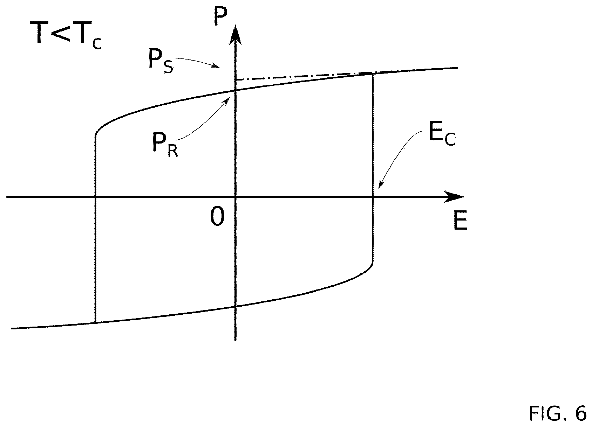

La caractéristique de la polarisation d'un matériau ferroélectrique dans sa phase ferroélectrique (i.e. pour T<T_{c}) en fonction du champ électrique lui étant appliqué est illustrée en figure 6. On remarque un phénomène d'hystérésis qui est couramment utilisé en microélectronique pour des applications mémoires. Il existe en effet des transistors dits FeFET présentant une grille ferromagnétique en face avant et permettant de stocker chacun un bit d'information. Dans ces dispositifs, une brève impulsion du potentiel appliqué sur la grille avant du FeFET induit un courant I_{DS} permanent et constant. Plus précisément, cette impulsion de potentiel, supérieure (ou inférieure) au potentiel coercitif +V_{C} (respectivement - V_{C}), provoque une polarisation constante +Pᵣ (respectivement -Pᵣ) du matériau ferroélectrique. Cette polarisation induit de façon permanente un courant source-drain, dont l'intensité, fonction de l'état de polarisation du matériau ferromagnétique, constitue un état mémoire qui peut être lu sans destruction de l'information. Notamment, l'état de polarisation, et donc l'information, se conservent lorsque le potentiel de grille est supprimé.

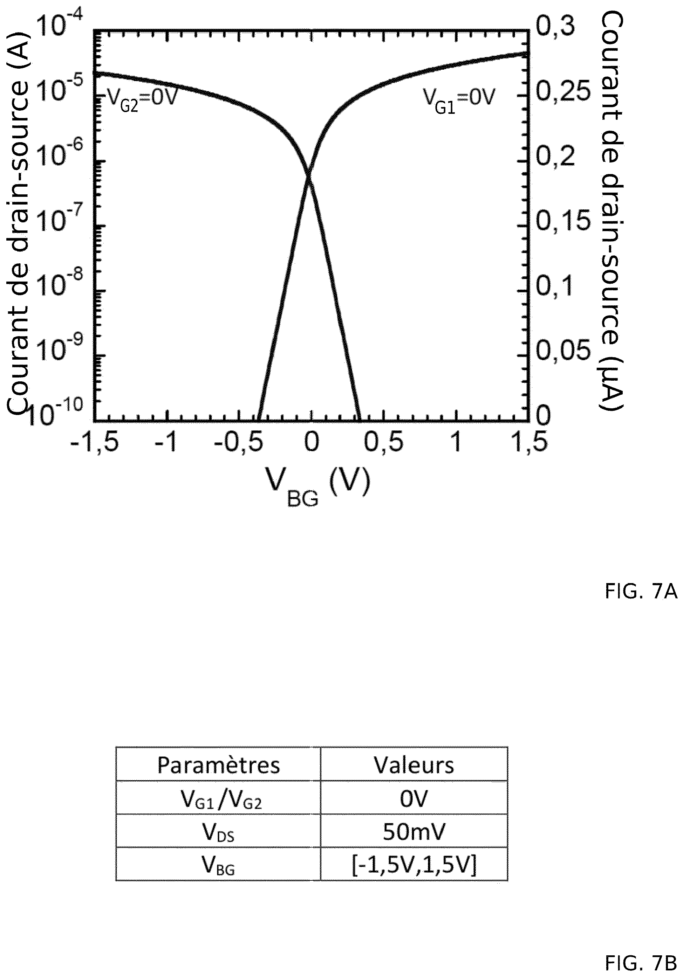

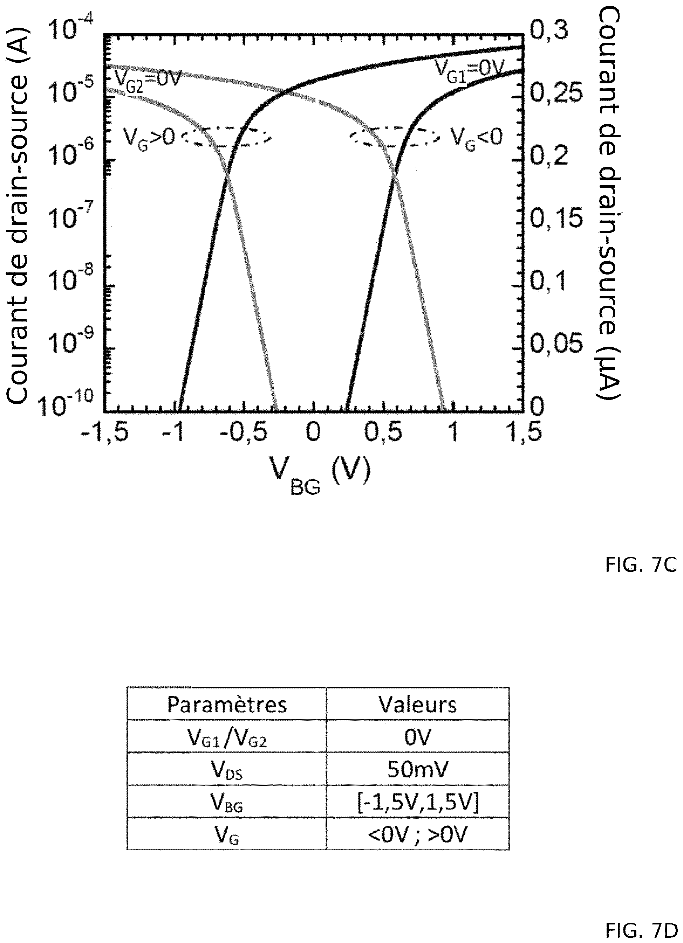

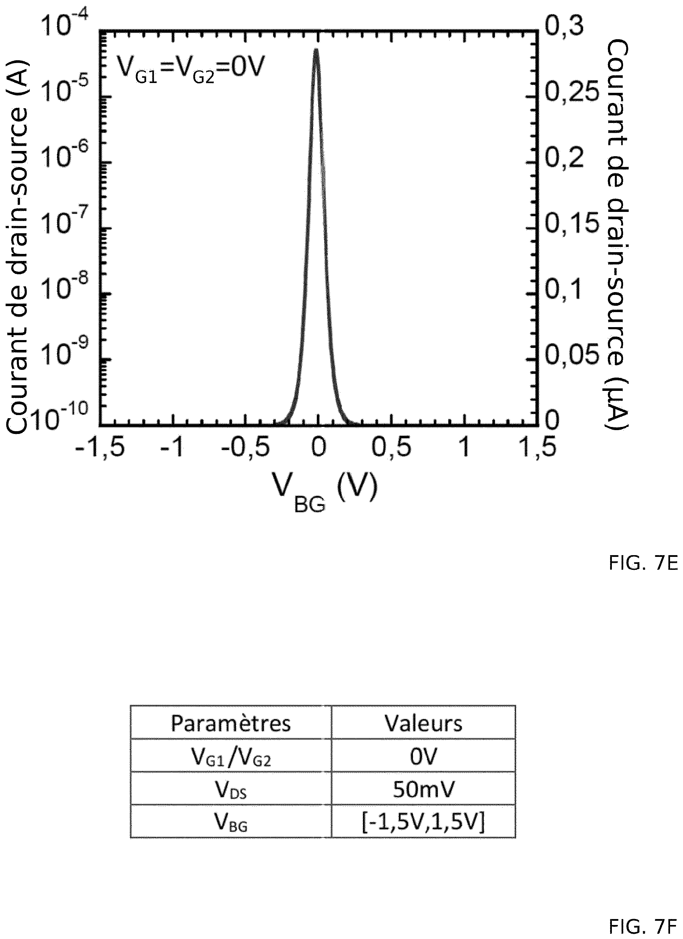

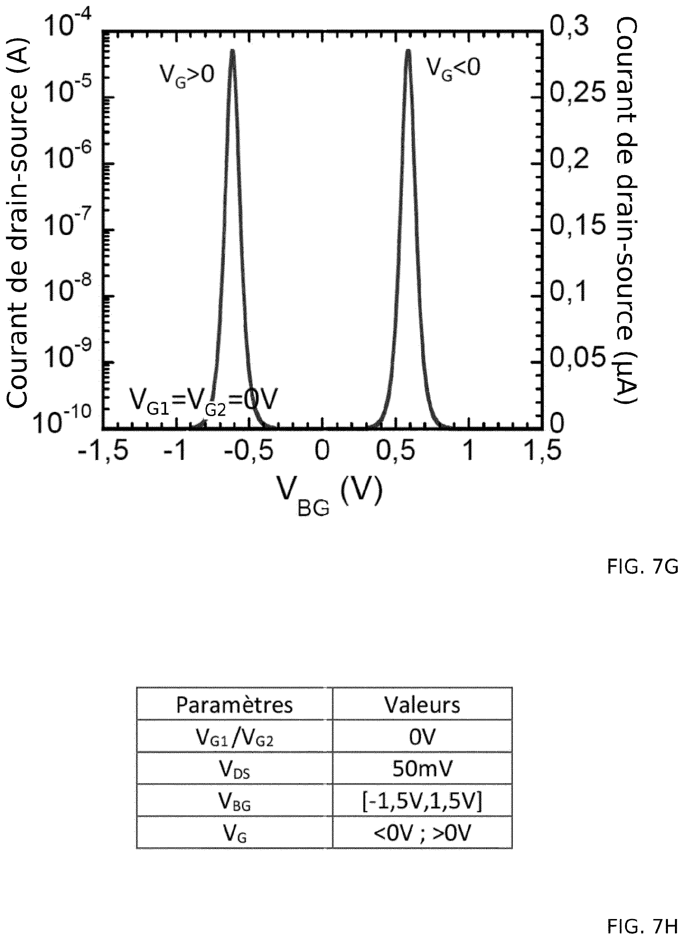

Par exemple, après application d'une tension de grille V_{GS} supérieure au potentiel coercitif +V_{C}, le canal du transistor devient conducteur et le courant résultant code pour une première information (par exemple un bit « 1 »). Cette information peut être effacée et changé en une deuxième information, telle un bit « 0 », en appliquant une tension de grille V_{GS} inférieure à -V_{C}. Les figures 7A et 7C représentent les caractéristiques courant-tension d'un transistor de l'état de la technique respectivement sans et avec matériau ferromagnétique. Les deux états pouvant être exploités pour des applications mémoire sont bien visibles sur la figure 7C.

Ce principe peut être appliqué au dispositif 1 selon l'invention et même optimisé. Il est en effet possible de paramétrer les tensions de grille V_{G1}, V_{G2} de façon à ce que les deux gaussiennes de la caractéristique courant-tension I_{D}=f(V_{BG}) du dispositif présentent des valeurs moyennes se situant à des valeurs de tension permettant la réalisation de portes logiques. Par exemple, l'état de polarisation des grilles en face avant 101, 201 (i.e. les tensions V_{G1}, V_{G2}) peut constituer une entrée (ou input) A, et la tension de grille arrière V_{BG} une entrée (ou input) B. Il est alors possible de faire coder :
- Une première gaussienne, correspondant à un premier état de polarisation, pour une valeur d'input A « 1 »,
- Une deuxième gaussienne, correspondant à un deuxième état de polarisation, pour une valeur d'input A « 0 »,
- Une première valeur de tension de grille arrière V_{BG,1} pour une valeur d'input B « 0 », et
- Une deuxième valeur de tension de grille arrière V_{BG,2} pour une valeur d'input B « 1 ».

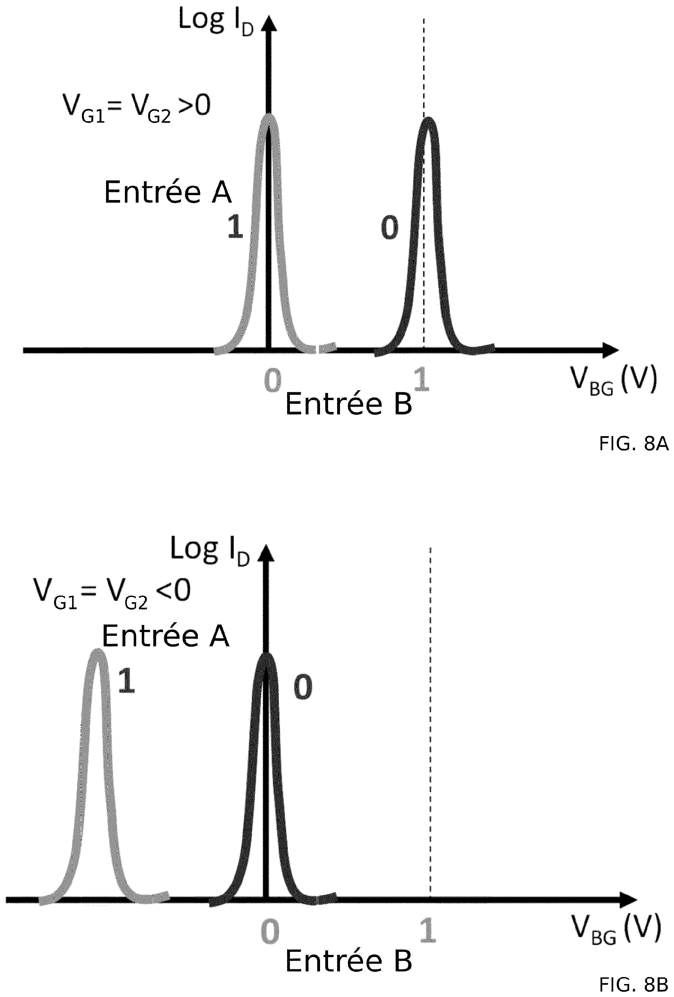

L'ensemble des portes logiques élémentaires peut alors être réalisées. Par exemple, la figure 8A illustre la réalisation d'une porte logique « ou exclusif » (couramment désigné sous l'acronyme anglais de « XOR »). Dans cette configuration :
- La valeur moyenne de la première gaussienne est égale à V_{BG,1}, et
- La valeur moyenne de la deuxième gaussienne est égale à V_{BG,2}.

Ainsi, si le dispositif 1 se trouve dans le premier état de polarisation (input A = « 1 ») et si la tension de grille arrière est fixée à V_{BG,1} (input B = « 0 »), le dispositif 1 est passant et un courant I_{D} peut être relevé, codant ainsi pour un bit « 1 ». En revanche, pour toute autre valeur de V_{BG}, le courant I_{D} sera nul (ou du moins significativement moins élevé), codant ainsi pour un bit « 0 ». Si, cette fois, le dispositif 1 se trouve dans le deuxième état de polarisation (input A = « 0 ») et si la tension de grille arrière est fixée à V_{BG,2} (input B = « 1 »), le dispositif 1 est passant et un courant I_{D} peut être relevé, codant ainsi pour un bit « 1 ». En revanche, pour toute autre valeur de V_{BG}, le courant I_{D} sera nul (ou du moins significativement moins élevé), codant ainsi pour un bit « 0 ». Ces différents cas de figure sont récapitulés dans la table 1. Comme le montre la dernière colonne de ce tableau, cette configuration permet bien de réaliser une fonction logique « XOR ».

| Paramètre physique | V_{G1}, V_{G2} | V_{BG} | I_{D} |
|---|---|---|---|
| Equivalent logique | A | B | A XOR B |
| Valeur | 0 | 0 | 0 |
| | 0 | 1 | 1 |
| | 1 | 0 | 1 |
| | 1 | 1 | 0 |

La figure 8B illustre quant à elle la réalisation d'une porte logique « NON-OU » (couramment désigné sous l'acronyme anglais de « NOR »). Dans cette configuration :
- La valeur moyenne de la première gaussienne est différente de V_{BG,1} et de V_{BG,2}, et
- La valeur moyenne de la deuxième gaussienne est égale à V_{BG,1}.

Ainsi, si le dispositif 1 se trouve dans le premier état de polarisation (input A = « 1 »), quelle que soit la valeur de la tension de grille arrière (input B = « 0 » ou « 1 »), le dispositif 1 est bloqué. Aucun courant ne peut être relevé (ou seul un courant très faible), codant ainsi pour un bit « 0 ». Si, cette fois, le dispositif 1 se trouve dans le deuxième état de polarisation (input A = « 0 ») et si la tension de grille arrière est fixée à V_{BG,1} (input B = « 0 »), le dispositif 1 est passant et un courant I_{D} peut être relevé, codant ainsi pour un bit « 1 ». En revanche, pour toute autre valeur de V_{BG}, le courant I_{D} sera nul (ou du moins significativement moins élevé), codant ainsi pour un bit « 0 ». Ces différents cas de figure sont récapitulés dans la table 2. Comme le montre la dernière colonne de ce tableau, cette configuration permet bien de réaliser une fonction logique « NOR ».

| Paramètre physique | V_{G1}, V_{G2} | V_{BG} | I_{D} |
|---|---|---|---|
| Equivalent logique | A | B | A NOR B |
| Valeur | 0 | 0 | 1 |
| | 0 | 1 | 0 |
| | 1 | 0 | 0 |
| | 1 | 1 | 0 |

Il a été montré que le dispositif 1 pouvait permettre de réaliser les portes logiques XOR et NOR, mais il est entendu que toutes les autres portes logiques élémentaires (AND, OR, NOT, NAND, XNOR) sont réalisables en adaptant la position des première et deuxième gaussiennes.

Ainsi, par un simple réglage des deux tensions de grilles V_{G1}, V_{G2}, le dispositif 1 permet de réaliser efficacement l'ensemble des portes logiques élémentaires, ce que ne permettent pas les transistors FDSOI classiques qui, eux, ne peuvent être contrôlés qu'au niveau d'une seule grille avant.

Selon un mode de réalisation, le dispositif 1 comprend un circuit de contrôle permettant d'appliquer les tensions précédemment mentionnées sur chacune des électrodes. Le circuit de contrôle permet en outre de faire varier les tensions V₁₁₀, V₂₁₀, V_{G1}, V_{G2} et V_{BG}, par exemple dans une plage donnée telle que [-5V, 5V].

Le circuit de contrôle est avantageusement configuré pour pouvoir générer des caractéristiques présentant une forme de gaussienne.

La génération d'une caractéristique de type gaussienne peut notamment être utile dans des applications de in-memory computing (terme anglais pouvant être traduit en français par « calcul en mémoire »). Par exemple, il est possible de réaliser des cellules mémoires non-volatiles servant à réaliser des opérations logiques élémentaires en exploitant le dispositif 1 tel que décrit précédemment.

Le dispositif 1 pourrait également être utilisé pour des applications de classification, par exemple dans le domaine de l'apprentissage machine. La classification est un aspect important de l'analyse des données exploratoire et décisionnelle. Elle a pour objectif de déterminer si un ensemble d'objets est homogène et, lorsqu'il ne l'est pas, d'établir une partition de cette collection en sous-ensembles homogènes appelés classes. Le modèle de mélange gaussien, illustré en figure 9, est une combinaison linéaire (courbe pleine) de plusieurs composantes gaussiennes (courbes en pointillés). Il est particulièrement utilisé dans le cas où les données en études ne peuvent pas être modélisées par une simple gaussienne. En d'autres termes, si la structure de données est composée naturellement de plusieurs groupes, il faut les représenter par un modèle de mélange gaussien plutôt qu'une simple distribution gaussienne.

Toujours dans le cadre de l'apprentissage machine, les gaussiennes générées par le dispositif 1 pourraient également être utilisées pour définir le poids synaptique entre deux neurones, notamment dans l'étude des réseaux de neurones Bayésien.

L'invention n'est pas limitée aux modes de réalisations précédemment décrits et s'étend à tous les modes de réalisation couverts par l'invention.

## Revendications

1. Dispositif microélectronique (1) comprenant :
• un premier transistor (100) à effet de champ comprenant un premier drain, une première source, une première grille (101), un premier diélectrique de grille (102), et un premier canal (103),
• une première zone dopée (110), constituant l'un parmi le premier drain et la première source,
• une deuxième zone dopée (120), constituant l'autre parmi le premier drain et la première source,
• un deuxième transistor (200) à effet de champ comprenant un deuxième drain, une deuxième source, une deuxième grille (201) et un deuxième diélectrique de grille (202), et un deuxième canal (203),
• une troisième zone dopée (210), constituant la deuxième source si la première zone dopée (110) constitue le premier drain, ou le deuxième drain, si la première zone dopée (110) constitue la première source,
• une quatrième zone dopée (220), constituant l'autre parmi le deuxième drain et la deuxième source,
• une couche diélectrique (300) présentant une face supérieure (301) au contact de la première zone dopée (110), de la deuxième zone dopée (120), de la troisième zone dopée (210) et de la quatrième zone dopée (220),
• une grille arrière (400) au contact d'une face inférieure (302) de la couche diélectrique (300),
dans lequel la deuxième zone dopée (120) et la quatrième zone dopée (220) forment une électrode commune (1000), et dans lequel la première zone dopée (110), la deuxième zone dopée (120), le premier canal (103), la troisième zone dopée (210), la quatrième zone dopée (220) et le deuxième canal (203), sont à base du même matériau, le dispositif étant **caractérisé en ce que** la deuxième zone dopée (120) et la quatrième zone dopée (220) présentent un dopage de même type parmi un dopage de type N et un dopage de type P, et **en ce que** la première zone dopée (110) et la troisième zone dopée (210) présentent un dopage de l'autre type.

2. Dispositif (1) selon la revendication précédente dans lequel la deuxième zone dopée (120) et la quatrième zone dopée (220) sont électriquement connectées par une couche électriquement conductrice (500), de préférence métallique.

3. Dispositif (1) selon la revendication précédente dans lequel la couche électriquement conductrice est à base de siliciure métallique.

4. Dispositif (1) selon l'une quelconque des revendications 2 et 3 dans lequel la couche électriquement conductrice (500) recouvre directement au moins une partie d'une face supérieure (121) de la deuxième zone dopée (120) et au moins une partie d'une face supérieure (221) de la quatrième zone dopée (220).

5. Dispositif (1) selon l'une quelconque des revendications 2 à 4 dans lequel la couche électriquement conductrice (500) recouvre directement une partie de la face supérieure (301) de la couche diélectrique (300) et sépare la deuxième zone dopée (120) de la quatrième zone dopée (220).

6. Dispositif (1) selon l'une quelconque des revendications précédentes comprenant une première électrode (115) et une deuxième électrode (215), et dans lequel la première zone dopée (110) est au contact de la première électrode (115) qui est configurée pour recevoir une première tension de commande V₁₁₀ et la troisième zone dopée (210) est au contact de la deuxième électrode (215) qui est configurée pour recevoir une deuxième tension de commande V₂₁₀.

7. Dispositif (1) selon la revendication précédente dans lequel :
• La première tension de commande V₁₁₀ constitue une tension de source V_{S} du dispositif (1) et la deuxième tension de commande V₂₁₀ constitue une tension de drain V_{D} du dispositif (1), ou
• La deuxième tension de commande V₂₁₀ constitue une tension de source V_{S} du dispositif (1) et la première tension de commande V₁₁₀ constitue une tension de drain V_{D} du dispositif (1).

8. Dispositif (1) selon l'une quelconque des revendications précédentes comprenant une première électrode de grille (105) et une deuxième électrode de grille (205), et dans lequel la première grille (101) est au contact de la première électrode de grille (105) qui est configurée pour recevoir l'application d'une première tension de grille V_{G1} et la deuxième grille (201) est au contact de la deuxième électrode de grille (205) qui est configurée pour recevoir l'application d'une deuxième tension de grille V_{G2}.

9. Dispositif (1) selon l'une quelconque des revendications précédentes comprenant une électrode de grille arrière (405) et dans lequel la grille arrière (400) est au contact de l'électrode de grille arrière (405) qui est configurée pour recevoir l'application d'une tension de grille arrière V_{BG}.

10. Dispositif (1) selon les revendications 6, 8 et 9 en combinaison comprenant en outre un circuit de contrôle configuré pour appliquer :
• la première tension de commande V₁₁₀ sur la première électrode (115),
• la deuxième tension de commande V₂₁₀ sur la deuxième électrode (215),
• la première tension de grille V_{G1} sur la première électrode (105),
• la deuxième tension de grille V_{G2} sur la deuxième électrode (205),
• la tension de grille arrière V_{BG} sur l'électrode de grille arrière (405),
la première tension de commande V₁₁₀, la deuxième tension de commande V₂₁₀, la première tension de grille V_{G1}, la deuxième tension de grille V_{G2} et la tension de grille arrière V_{BG} pouvant prendre différentes valeurs et au moins des valeurs comprises entre -5 et 5 V.

11. Dispositif (1) selon la revendication précédente dans lequel V_{G2} = ± V_{G1} + ΔV_{G}, et avec ΔV_{G} compris entre -5 et +5 V.

12. Dispositif (1) selon la revendication 10 dans lequel V_{G2} = V_{G1}

13. Dispositif (1) selon la revendication 10 dans lequel V_{G2}= -V_{G1}.

14. Dispositif (1) selon l'une quelconque des revendications précédentes dans lequel le premier transistor (100) et le deuxième transistor (200) sont séparés d'une distance L supérieure à 50 nm, et/ou inférieure à 500 nm.

15. Dispositif (1) selon l'une quelconque des revendications précédentes dans lequel la couche diélectrique (300) présente une épaisseur e₃₀₀ entre sa face inférieure (302) et sa face supérieure (301) inférieure ou égale à 25 nm, de préférence inférieure à 5 nm.

16. Dispositif (1) selon l'une quelconque des revendications précédentes dans lequel le premier diélectrique de grille (102) et le deuxième diélectrique de grille (202) sont à base d'un matériau ferroélectrique.

17. Unité de stockage à mémoire non-volatile comprenant au moins un dispositif (1) selon la revendication précédente.

18. Procédé de contrôle du dispositif (1) selon l'une quelconque des revendications 2 à 16 ou de l'unité de stockage selon la revendication précédente, dans lequel la première tension de commande V₁₁₀ est appliquée à la première zone dopée (110) et la deuxième tension de commande V₂₁₀ est appliquée à la première zone dopée (210), et dans lequel :
• La première tension de commande V₁₁₀ constitue une tension de source V_{S} du dispositif (1) et la deuxième tension de commande V₂₁₀ constitue une tension de drain V_{D} du dispositif (1), ou
• La deuxième tension de commande V₂₁₀ constitue la tension de source V_{S} du dispositif (1) et la première tension de commande V₁₁₀ constitue la tension de drain V_{D} du dispositif (1).

## Patentansprüche

1. Mikroelektronische Anordnung (1), umfassend:
• einen ersten Feldeffekttransistor (100), der einen ersten Drain, eine erste Source, ein erstes Gate (101), ein erstes Gate-Dielektrikum (102) und einen ersten Kanal (103) umfasst,
• eine erste dotierte Zone (110), die eines des ersten Drain und der ersten Source bildet,
• eine zweite dotierte Zone (120), die das andere des ersten Drain und der ersten Source bildet,
• einen zweiten Feldeffekttransistor (200), der einen zweiten Drain, eine zweite Source, ein zweites Gate (201) und ein zweites Gate-Dielektrikum (202) und einen zweiten Kanal (203) umfasst,
• eine dritte dotierte Zone (210), die die zweite Source bildet, wenn die erste dotierte Zone (110) den ersten Drain bildet, oder den zweiten Drain, wenn die erste dotierte Zone (110) die erste Source bildet,
• eine vierte dotierte Zone (220), die das andere des zweiten Drain und der zweiten Source bildet,
• eine dielektrische Schicht (300), die eine obere Fläche (301) in Kontakt mit der ersten dotierten Zone (110), der zweiten dotierten Zone (120), der dritten dotierten Zone (210) und der vierten dotierten Zone (220) aufweist,
• ein Back-Gate (400) in Kontakt mit einer unteren Fläche (302) der dielektrischen Schicht (300),
wobei die zweite dotierte Zone (120) und die vierte dotierte Zone (220) eine gemeinsame Elektrode (1000) bilden, und wobei die erste dotierte Zone (110), die zweite dotierte Zone (120), der erste Kanal (103), die dritte dotierte Zone (210), die vierte dotierte Zone (220) und der zweite Kanal (203) auf demselben Material basieren, wobei die Anordnung **dadurch gekennzeichnet ist, dass** die zweite dotierte Zone (120) und die vierte dotierte Zone (220) eine Dotierung desselben Typs aus einer Dotierung vom Typ N und einer Dotierung vom Typ P aufweisen, und dass die erste dotierte Zone (110) und die dritte dotierte Zone (210) eine Dotierung des anderen Typs aufweisen.

2. Anordnung (1) nach dem vorstehenden Anspruch, wobei die zweite dotierte Zone (120) und die vierte dotierte Zone (220) elektrisch durch eine elektrisch leitfähige Schicht (500), die bevorzugt metallisch ist, verbunden sind.

3. Anordnung (1) nach dem vorstehenden Anspruch, wobei die elektrisch leitfähige Schicht auf Metallsilizid basiert.

4. Anordnung (1) nach einem der Ansprüche 2 und 3, wobei die elektrisch leitfähige Schicht (500) direkt mindestens einen Teil einer oberen Fläche (121) der zweiten dotierten Zone (120) und mindestens einen Teil einer oberen Fläche (221) der vierten dotierten Zone (220) abdeckt.

5. Anordnung (1) nach einem der Ansprüche 2 bis 4, wobei die elektrisch leitfähige Schicht (500) direkt einen Teil einer oberen Fläche (301) der dielektrischen Schicht (300) abdeckt und die zweite dotierte Zone (120) von der vierten dotierten Zone (220) trennt.

6. Anordnung (1) nach einem der vorstehenden Ansprüche, die eine erste Elektrode (115) und eine zweite Elektrode (215) umfasst, und wobei die erste dotierte Zone (110) mit der ersten Elektrode (115) in Kontakt ist, die dazu konfiguriert ist, eine erste Steuerspannung V₁₁₀ zu empfangen, und die dritte dotierte Zone (210) mit der zweiten Elektrode (215) in Kontakt ist, die dazu konfiguriert ist, eine zweite Steuerspannung V₂₁₀ zu empfangen.

7. Anordnung (1) nach dem vorstehenden Anspruch, wobei:
• die erste Steuerspannung V₁₁₀ eine Source-Spannung V_{S} der Anordnung (1) bildet, und die zweite Steuerspannung V₂₁₀ eine Drain-Spannung V_{D} der Anordnung (1) bildet, oder
• die zweite Steuerspannung V₂₁₀ eine Source-Spannung V_{S} der Anordnung (1) bildet, und die erste Steuerspannung V₁₁₀ eine Drain-Spannung V_{D} der Anordnung (1) bildet.

8. Anordnung (1) nach einem der vorstehenden Ansprüche, die eine erste Gate-Elektrode (105) und eine zweite Gate-Elektrode (205) umfasst, und wobei das erste Gate (101) mit der ersten Gate-Elektrode (105) in Kontakt ist, die dazu konfiguriert ist, das Anlegen einer ersten Gate-Spannung V_{G1} zu empfangen, und das zweite Gate (201) mit der zweiten Gate-Elektrode (205) in Kontakt ist, die dazu konfiguriert ist, das Anlegen einer zweiten Gate-Spannung V_{G2} zu empfangen.

9. Anordnung (1) nach einem der vorstehenden Ansprüche, die eine Back-Gate-Elektrode (405) umfasst und wobei das Back-Gate (400) mit der Back-Gate-Elektrode (405) in Kontakt ist, die dazu konfiguriert ist, das Anlegen einer Back-Gate-Spannung V_{BG} zu empfangen.

10. Anordnung (1) nach den Ansprüchen 6, 8 und 9 in Kombination, die außerdem eine Steuerschaltung umfasst, die zum Anlegen der Folgenden konfiguriert ist:
• erste Steuerspannung V₁₁₀ an der ersten Elektrode (115),
• zweite Steuerspannung V₂₁₀ an der zweiten Elektrode (215) ,
• erste Gate-Spannung V_{G1} an der ersten Elektrode (105),
• zweite Gate-Spannung V_{G2} an der zweiten Elektrode (205),
• Back-Gate-Spannung V_{BG} an der Back-Gate-Elektrode (405),
wobei die erste Steuerspannung V₁₁₀, die zweite Steuerspannung V₂₁₀, die erste Gate-Spannung V_{G1}, die zweite Gate-Spannung V_{G2} und die Back-Gate-Spannung V_{BG} unterschiedliche Werte und mindestens Werte zwischen -5 und 5 V annehmen können.

11. Anordnung (1) nach dem vorstehenden Anspruch, wobei V_{G2} = ± V_{G1} + ΔV_{G}, und wobei ΔV_{G} zwischen -5 und +5 V liegt.

12. Anordnung (1) nach Anspruch 10, wobei V_{G2} = V_{G1}.

13. Anordnung (1) nach Anspruch 10, wobei V_{G2} = -V_{G1} ist.

14. Anordnung (1) nach einem der vorstehenden Ansprüche, wobei der erste Transistor (100) und der zweite Transistor (200) um einen Abstand L größer als 50 nm und/oder kleiner als 500 nm getrennt sind.

15. Anordnung (1) nach einem der vorstehenden Ansprüche, wobei die dielektrische Schicht (300) eine Dicke e300 zwischen ihrer unteren Fläche (302) und ihrer oberen Fläche (301) kleiner oder gleich 25 nm, bevorzugt kleiner als 5 nm aufweist.

16. Anordnung (1) nach einem der vorstehenden Ansprüche, wobei das erste Gate-Dielektrikum (102) und das zweite Gate-Dielektrikum (202) auf einem ferroelektrischen Material basieren.

17. Speichereinheit mit nichtflüchtigem Speicher, die mindestens eine Anordnung (1) nach dem vorstehenden Anspruch umfasst.

18. Steuerverfahren der Anordnung (1) nach einem der Ansprüche 2 bis 16 oder der Speichereinheit gemäß dem vorstehenden Anspruch, wobei die erste Steuerspannung V₁₁₀ an die erste dotierte Zone (110) angelegt wird und die zweite Steuerspannung V₂₁₀ an die erste dotierte Zone (210) angelegt wird, und wobei:
• die erste Steuerspannung V₁₁₀ eine Source-Spannung V_{S} der Anordnung (1) bildet, und die zweite Steuerspannung V210 eine Drain-Spannung V_{D} der Anordnung (1) bildet, oder
• die zweite Steuerspannung V₂₁₀ die Source-Spannung V_{S} der Anordnung (1) bildet, und die erste Steuerspannung V110 die Drain-Spannung V_{D} der Anordnung (1) bildet.

## Claims

1. Microelectronic device (1) comprising:
• a first field-effect transistor (100) comprising a first drain, a first source, a first gate (101), a first gate dielectric (102), and a first channel (103),
• a first doped zone (110), constituting one from among the first drain and the first source,
• a second doped zone (120), constituting the other from among the first drain and the first source,
• a second field-effect transistor (200) comprising a second drain, a second source, a second gate (201) and a second gate dielectric (202), and a second channel (203),
• a third doped zone (210), constituting the second source if the first doped zone (110) constitutes the first drain, or the second drain, if the first doped zone (110) constitutes the first source,
• a fourth doped zone (220), constituting the other from among the second drain and the second source,
• a dielectric layer (300) having an upper face (301) in contact with the first doped zone (110), with the second doped zone (120), with the third doped zone (210) and with the fourth doped zone (220),
• a rear gate (400) in contact with a lower face (302) of the dielectric layer (300),
in which the second doped zone (120) and the fourth doped zone (220) form a common electrode (1000), and in which the first doped zone (110), the second doped zone (120), the first channel (103), the third doped zone (210), the fourth doped zone (220) and the second channel (203), are with the basis of the same material, the device being **characterised in that** the second doped zone (120) and the fourth doped zone (220) have a doping of the same type from among an N-type doping and a P-type doping, and **in that** the first doped zone (110) and the third doped zone (210) have a doping of the other type.

2. Device (1) according to the preceding claim, wherein the second doped zone (120) and the fourth doped zone (220) are electrically connected by an electrically conductive layer (500), preferably metallic.

3. Device (1) according to the preceding claim, wherein the electrically conductive layer is metal silicide-based.

4. Device (1) according to any one of claims 2 and 3, wherein the electrically conductive layer (500) directly covers at least one part of an upper face (121) of the second doped zone (120) and at least one part of an upper face (221) of the fourth doped zone (220).

5. Device (1) according to any one of claims 2 to 4, wherein the electrically conductive layer (500) directly covers a part of the upper face (301) of the dielectric layer (300) and separates the second doped zone (120) from the fourth doped zone (220).

6. Device (1) according to any one of the preceding claims comprising a first electrode (115) and a second electrode (215), and wherein the first doped zone (110) is in contact with the first electrode (115) which is configured to receive a first control voltage V₁₁₀ and the third doped zone (210) is in contact with the second electrode (215) which is configured to receive a second control voltage V₂₁₀.

7. Device (1) according to the preceding claim, wherein:
• The first control voltage V₁₁₀ constitutes a source voltage V_{S} of the device (1) and the second control voltage V₂₁₀ constitutes a drain voltage V_{D} of the device (1), or
• The second control voltage V₂₁₀ constitutes a source voltage V_{S} of the device (1) and the first control voltage V₁₁₀ constitutes a drain voltage V_{D} of the device (1).

8. Device (1) according to any one of the preceding claims comprising a first gate electrode (105) and a second gate electrode (205), and wherein the first gate (101) is in contact with the first gate electrode (105) which is configured to receive the application of a first gate voltage V_{G1} and the second gate (201) is in contact with the second gate electrode (205) which is configured to receive the application of a second gate voltage V_{G2}.

9. Device (1) according to any one of the preceding claims comprising a rear gate electrode (405), and wherein the rear gate (400) is in contact with the rear gate electrode (405) which is configured to receive the application of a rear gate voltage V_{BG}.

10. Device (1) according to claims 6, 8 and 9 combined, further comprising a control circuit configured to apply:
• the first control voltage V₁₁₀ on the first electrode (115),
• the second control voltage V₂₁₀ on the second electrode (215),
• the first gate voltage V_{G1} on the first electrode (105),
• the second gate voltage V_{G2} on the second electrode (205),
• the rear gate voltage V_{BG} on the rear gate electrode (405),
the first control voltage V₁₁₀, the second control voltage V₂₁₀, the first gate voltage V_{G1}, the second gate voltage V_{G2} and the rear gate voltage V_{BG} being able to take different values and at least values of between -5 and 5V.

11. Device (1) according to the preceding claim, wherein V_{G2} = ± V_{G1} + ΔV_{G}, and with ΔV_{G} between -5 and +5V.

12. Device (1) according to claim 10, wherein V_{G2} = V_{G1}.

13. Device (1) according to claim 10, wherein V_{G2} = -V_{G1}.

14. Device (1) according to any one of the preceding claims, wherein the first transistor (100) and the second transistor (200) are separated by a distance L greater than 50nm, and/or less than 500nm.

15. Device (1) according to any one of the preceding claims, wherein the dielectric layer (300) has a thickness e₃₀₀ between its lower face (302) and its upper face (301) less than or equal to 25nm, preferably less than 5nm.

16. Device (1) according to any one of the preceding claims, wherein the first gate dielectric (102) and the second gate dielectric (202) are with the basis of a ferroelectric material.

17. Non-volatile memory storage unit comprising at least one device (1) according to the preceding claim.

18. Method for controlling the device (1) according to any one of claims 2 to 16 or the storage unit according to the preceding claim, wherein the first control voltage V₁₁₀ is applied to the first doped zone (110) and the second control voltage V₂₁₀ is applied to the first doped zone (210), and wherein:
• The first control voltage V₁₁₀ constitutes a source voltage V_{S} of the device (1) and the second control voltage V₂₁₀ constitutes a drain voltage V_{D} of the device (1), or
• The second control voltage V₂₁₀ constitutes the source voltage V_{S} of the device (1) and the first control voltage V₁₁₀ constitutes the drain voltage V_{D} of the device (1).
